# EUROPEAN PATENT SPECIFICATION

(11) **EP 1 145 413 B1**
(45) Date of publication and mention of the grant of the patent: **19.11.2008**
(21) Application number: 99936638.8
(22) Date of filing: 30.07.1999
(51) Int. Cl.: H02M 1/12, H02M 1/14

(54) **ARRANGEMENT FOR ELIMINATING RADIO INTERFERENCES IN AN ELECTRONIC POWER REGULATOR**
ANORDNUNG ZUR FUNKENTSTÖRUNG IN EINEM ELEKTRISCHEN STROMREGLER
DISPOSITIF ELIMINANT LES PARASITES RADIO DANS UN REGULATEUR ELECTRONIQUE DE TENSION

(30) Priority: 31.07.1998 FI 981686
(43) Date of publication of application: 17.10.2001
(73) Proprietor: Oy Lexel Finland AB, 02650 Espoo (FI)
(72) Inventor: SAIRANEN, Martti, FIN-01800 Klaukkala (FI); ÅBERG, Kari, FIN-02680 Espoo (FI)
(74) Representative: Tanhua, Pekka Vilhelm
(86) International application number: PCT/FI1999/000646
(87) International publication number: WO 2000/008740

(56) References cited:
- EP-A1- 0 674 390
- WO-A1-98/15886
- US-A- 4 701 645

## Description

The invention relates to an arrangement for eliminating radio interference in an electronic power regulator according to the preamble of claim 1.

In the prior art there is known, WO 98/15886, an improved electronic power regulator in order to regulate the AC power supplied to the load. The power regulator comprises a switching unit and a control unit thereof, said switching unit being coupled in series with the load. The switching unit comprises two semiconductor switching units coupled in parallel, the first being a transistor switching unit and the second a tyristor switching unit. The control unit comprises a synchronisation unit and a regulation unit. By means of the synchronisation unit, the supply voltage prevailing over the load and the switching unit is observed, and there is obtained information as regards the zero points of the supply voltage. By means of the regulation unit, the first and second semiconductor switching unit are switched to conductive state on the basis of the information obtained from the synchronisation unit, so that first the transistor switching unit is switched to conductive state, and thereafter the tyristor switching unit, and this is realised repeatedly during the half-cycle, at a desired point of time with respect to the supply voltage zero point, and both semiconductor switching units are switched to cut-off state essentially at the zero point of the load current.

By means of the electronic power regulator described above, it is attempted to eliminate all radio interference caused by tyristor switches. This is realised by means of a transistor switching unit arranged in parallel with the tyristor switching unit. Radio interference is eliminated by first switching the transistor switching unit to conductive state, prior to the tyristor switching unit. The transistor switching unit, which advantageously is realised by means of at least one pair of field effect transistors or a corresponding pair of switching transistors, can be switched on in a controlled manner, in which case, by restricting the switching rate, the rate of current rise can be regulated, and thereby the creation of radio interference prevented. When the load current is made to proceed in a controlled manner through the transistor switching unit of the power regulator, the transistor switching unit is switched to conductive state as the second switching unit in parallel to the transistor switching unit. Now the major part of the load current starts to proceed through the tyristor switching unit, provided that the voltage created over the transistors of the transistor switching unit is higher than the threshold voltage of the tyristors or the triac of the tyristor switching unit. Conductivity losses restrict the voltage prevailing over the tyristor switching unit. Said losses behave in a nearly linear fashion according to current changes after a given threshold current value.

A drawback with the above described electronic power regulator is that radio interference is not totally eliminated. This is due to the fact that over the conductive field effect transistor pair or a corresponding transistor switching unit, there prevails a given voltage, which is higher than the voltage prevailing over the conductive tyristor switching unit. When the tyristor switching unit is cut off, this results in a sudden drop in the voltage and a corresponding rise in the current, which causes radio interference.

The object of the invention is to eliminate said drawback. Another object of the invention is to introduce a new and improved arrangement for eliminating radio interference in an electronic power regulator, whereby there is realised a reliable and simple power regulator with low power losses.

The arrangement according to the invention for eliminating radio interference in an electronic power regulator is characterised by what is specified in the appended claim 1.

The invention relates to an arrangement for eliminating radio interference in an electronic power regulator. The power regulator comprises a switching unit and a control unit, said control unit comprising two semiconductor switching units coupled in parallel, the first being a transistor switching unit and the second a tyristor switching unit, said switching unit being coupled in series with the load; the power regulator regulates the AC power supplied in the load, so that by means of the control unit, at a given point of time during the half-cycle of the supply voltage, the transistor switching unit is first switched to conductive state, and immediately thereafter the tyristor switching unit is likewise switched to conductive state, and most advantageously both switching units are switched to cut-off state at the next zero point of the half-cycle. According to the invention, the arrangement includes a coil with a low inductance value, or a corresponding inductor, which is arranged in series with the tyristor switching unit, so that the tyristor switching unit and the inductance are coupled in parallel with the transistor switching unit.

An advantage of the invention is that by means of the arrangement, there is efficiently eliminated all radio interference that is created when the tyristor switching unit is switched to conductive state after first switching the transistor switching unit to conductive state.

Another advantage of the invention is that the coil, or more generally the inductor, used in the arrangement is low in inductance and small in size. It is an economical and effective solution to the radio interference problem. Yet another advantage is that such a low inductance does not send disturbing noises to the surroundings.

The invention is explained in more detail below with respect to the appended drawing, where
- figure 1: is a diagrammatic illustration of an electronic power regulator where the arrangement according to the invention is applied;
- figure 2: illustrates an advantageous switching unit of the power source;
- figure 3: illustrates the current and voltage curves of the switching unit in switching situations;
- figure 4: illustrates a part of the current and voltage curves of figure 3, enlarged with respect to the time axis, when the switching unit is switched to conductive state;
- figure 5: illustrates the change of voltage in the load voltage, when the switching unit is switched to conductive state; and
- figure 6: illustrates the measurement results of the radio interference of the switching unit.

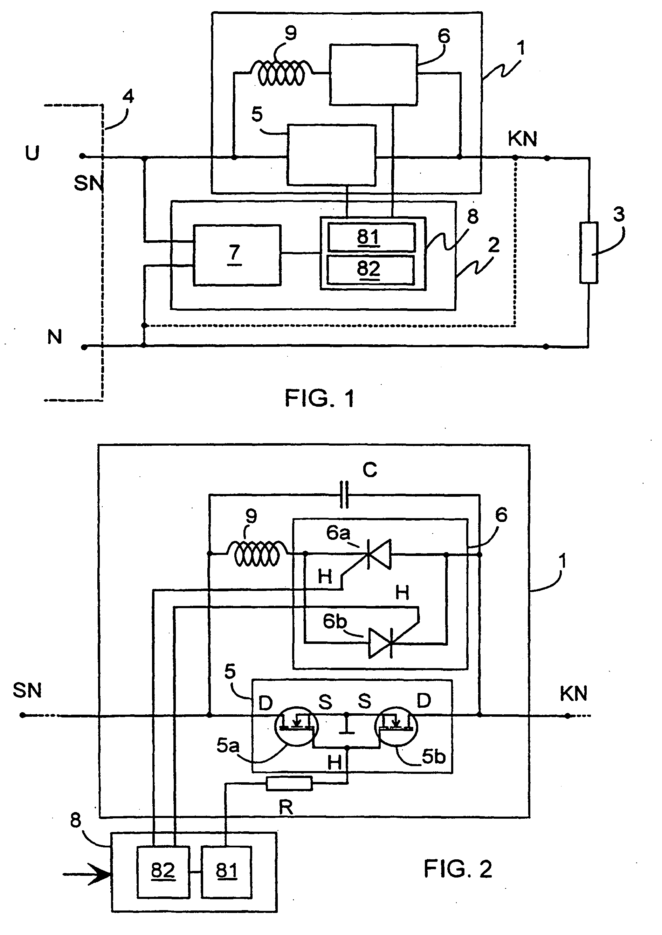

An electronic power regulator, where the arrangement according to the invention is applied, is illustrated as a block diagram in figure 1. The power regulator comprises a switching unit 1 and a control unit 2. The switching unit 1 is coupled in series with the load 3. The supply voltage source 4 is an AC current source, such as an electrical network. The switching unit 1 is controlled by the control unit 2, so that the desired power is fed in the load.

The switching unit 1 comprises two semiconductor switching units: a first, i.e. a transistor switching unit 5, and in parallel with it, a second, i.e. a tyristor switching unit 6. The control unit 2 comprises a synchronisation unit 7 and a regulation unit 8. The synchronisation unit 7 is coupled over the supply voltage source 4, over both the switching unit 1 and the load 3, so that by means thereof, there is observed the fluctuation of the supply voltage U, such as the mains voltage, prevailing over the switching unit 1 and the load 3, as well as the fluctuation of the current I passing therethrough, and at least the zero points of the voltage U are detected.

In connection with the electronic power regulator, there is provided an arrangement for eliminating radio interference. Said arrangement comprises a coil 9 with a low inductance value, or a corresponding inductor, which is arranged in series with the tyristor switching unit 6. In addition, the tyristor switching unit 6 and the coil 9 are coupled in parallel with the transistor switching unit 5.

By means of the synchronisation unit 7, the magnitude of the voltage prevailing over the switching unit 1 is observed, and thereby the magnitude of the load current, and thus the zero points of the load current can be defined (this is illustrated by means of a dotted line drawn from the synchronisation unit 7 to in between the switching unit 1 and the load 3).

The synchronising signal obtained from the synchronisation unit 7 and indicating the zero points is fed in the regulation unit 8. The regulation unit 8 include two regulation units 81, 82 in order to control the transistor switching unit 5 and the tyristor switching unit 6, constituting the switching unit 1, on the basis of the synchronising signal and the adjusted power, repeatedly to conductive state and to cut-off state.

In a preferred embodiment, the transistor switching unit 5 comprises a field effect transistor pair including two field effect transistors 5a, 5b, coupled in series. The source poles S of the field effect transistors 5a, 5b are coupled to each other and further to ground N, and the drain poles D are coupled to the input pole of the power regulator, i.e. to the supply pole SN of the mains voltage, and respectively to the output pole, i.e. to the load connecting pole KN. The grids H of the field effect transistor pair are coupled together, and the control voltage is fed therein. In this embodiment, the tyristor switching unit 6 includes a pair of tyristors, i.e. two tyristors 6a, 6b, coupled in parallel and conductive in opposite directions. On the grid H of both tyristors 6a, 6b, the control voltage is fed in turns, depending on whether the ongoing half-cycle of the supply voltage is positive or negative. In series with the tyristor pair 6a, 6b, there is coupled a coil 9. The tyristor pair 6a, 6b and the coil 9 are coupled in parallel with the above mentioned field effect transistor pair 5a, 5b.

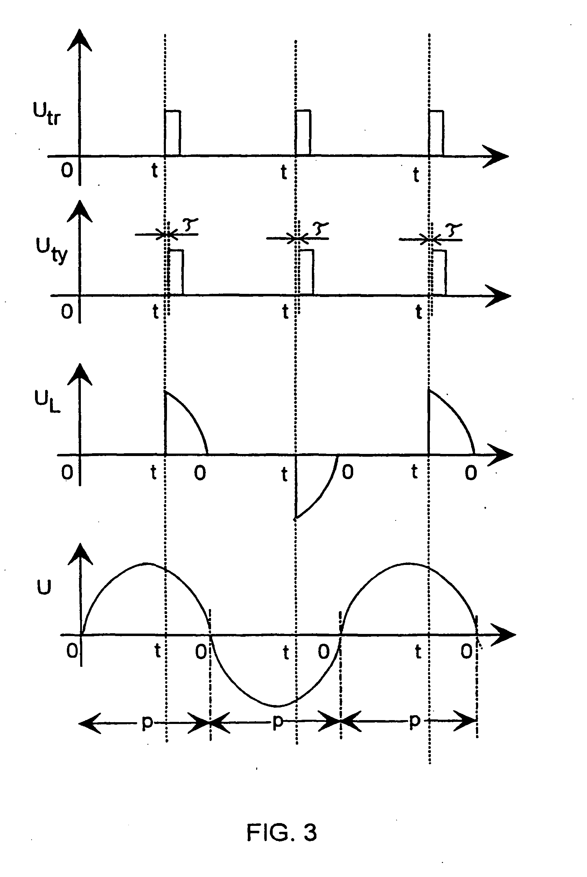

The electronic power regulator functions as follows. The switching unit 1 is switched to conductive state periodically and repeatedly during the half-cycle of the supply voltage U, at a point of time t after the zero point 0 of the supply voltage, as is illustrated in figure 3. The time t can be determined by the user at the adjusting device provided in connection with the regulation unit 8, which is for example a potentiometer, and it defines the duration of the current fed in the load during each half-cycle p, as well as the magnitude of the electric power fed in the load.

The electronic power regulator is controlled at two stages. It is based on synchronisation, where by means of a synchronisation unit 7, there is observed at least the momentary magnitude of the supply voltage U, and hence the magnitude of the voltage prevailing over the switching unit 1 and the load 3. By means of the synchronisation unit 7, there are detected at least the zero points of the supply voltage U. The switching unit 1 is controlled by means of the regulation unit 8; 81, 82, on the basis of the synchronising signals received from the synchronisation unit 7, so that at the first stage, under the control of the first regulation unit 81, by applying a suitable control voltage, the transistor switching unit 5 is slowly switched on, i.e. to conductive state. Here the slow switching on means that the rate of load current rise is limited, because it correlates directly with the creation of radio interference. Now the first regulation unit 81 includes a slow-down circuit for the rate of control voltage rise in order to switch the transistor switching unit 5 to conductive state in a controlled manner. In said slow-down circuit, there is utilised for instance the specific capacitance of the switching transistor, such as the channel capacitance of the field effect transistor, and/or a capacitance C coupled over the transistor, and a resistance R coupled to the control pole, such as the grid, which together define the RC circuit and the time constant for the rate of rise of the current passing through the switching unit. When the transistor switching unit 5 is switched to conductive state, the tyristor switching unit 6 is thereafter switched in turn, at a slight delay τ, to conductive state by means of a second regulation unit 82, as is illustrated in figure 3. Most advantageously the second regulation unit 82 in that case includes a suitable slow-down circuit, whereby the control voltage of the first regulation unit 81 is delayed.

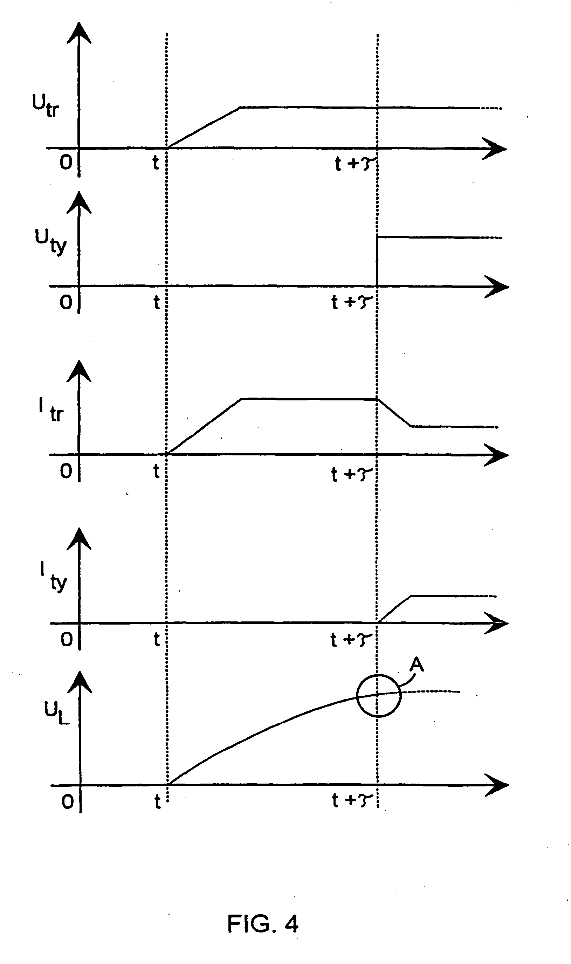

Figure 3 illustrates the control voltages U_{ty} and Uₜᵣ of the tyristor switching unit and the transistor switching unit respectively, as well as the load voltage U_{L} and the supply voltage U. Figure 4 illustrates, on a scale enlarged with respect to the time axis, said control voltages U_{ty}, Uₜᵣ, the current Iₜᵣ through the transistor switching unit and the current I_{ty} through the triac switching unit, as well as the load voltage U_{L} at the point of time when the transistor switching unit 5 and the tyristor switching unit 6 are switched to conductive state.

The switching of the switching unit 1 to cut-off state, i.e. its adjusting to nonconductive state, is advantageously carried out at the next zero point of the AC current supplied in the load 3. For the tyristor switching unit 6, the zero point of the load current is that current magnitude where the load current drops beneath the turn-off current of the tyristor switching unit 6a, 6b, which is about 1 mA. When the load current drops beneath the turn-off current, the tyristor switching unit is switched off.

The transistor switching unit 5 is switched to cut-off state at the next zero point of the supply voltage, i.e. in this case of the mains voltage U, by means of the synchronising pulse received from the synchronisation unit 7.

With a resistive load, the zero points of the supply voltage and the current match, but with an inductive load the load current conforms to the supply voltage at the phase shift. In that case the transistor switching unit 5 is advantageously switched to cut-off state only after the tyristor switching unit 6, when the load current drops beneath a predetermined turn-off current of the tyristor switching unit.

As an alternative, the voltage prevailing over the transistor switching unit 5 is observed by means of a suitable measuring arrangement of the synchronisation unit 7, and on the basis thereof, there is defined the zero point of the load current, where the transistor switching unit 5 is switched to cut-off state. The turn-off current of a transistor switching unit 5 which is realised by means of a field effect transistor pair, is of the order 200 µA. Now the transistor switching unit 5 is switched to cut-off state only after switching the tyristor switching unit 6 to cut-off state.

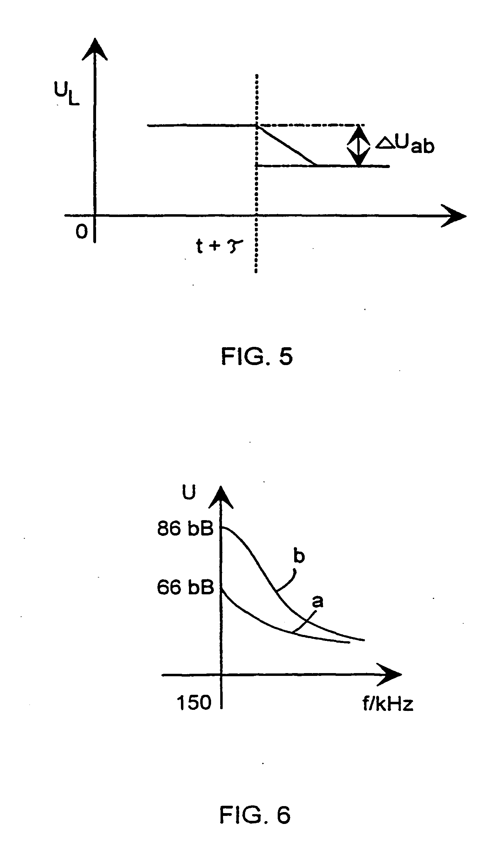

Let us now observe the influence of a coil 9 or a corresponding small inductor in the operation of the switching unit 1 described above. Let us assume that the coil 9 or a corresponding inductor is not found in the circuit. When the transistor switching unit 5 is in conductive state, i.e. over it, between the drain D and the source S, there prevails a slight voltage drop Uₐ, which is of the order 3 V. Respectively, the voltage drop U_{b} of the conductive tyristor switching unit 6 is of the order 1.5 V. In a switching situation, when the transistor switching unit 5 is conductive and the tyristor switching unit 6 is switched to conductive state at a point of time t + τ, the result is a sudden drop in the load voltage U_{L}, i.e. ΔU_{ab} = Uₐ - U_{b} = about 1. 5 V, which is illustrated by dotted lines in figure 5. The voltage drop ΔU_{ab} = Uₐ - U_{b} is followed by a sudden rise in the current, which causes radio interference. When a coil 9 with a low inductance value is arranged in series with the tyristor switching unit 6, as is illustrated in figures 1 and 2, the voltage drop ΔU_{ab} = Uₐ - U_{b} does not take place suddenly, but with a low gradient, as is illustrated in figure 5, and respectively the current does not rise suddenly. A low inductance resists any rapid change in the voltage/current, and thus the voltage drop ΔU_{ab} = Uₐ - U_{b} is evened out slowly, and radio interference is not created. It is pointed out that the magnitude of the load voltage U_{L} itself at the point of switching t + τ is of the order 300 V, when the supply voltage is taken normally from the mains.

Figure 6 illustrates measuring results, as regards radio interference, obtained from the switching unit 5, in connection with which there is arranged, in the manner described above, a small coil 9, curve a, and on the other hand from a switching unit without a coil 9, curve b. It can be seen that radio interference for instance at the frequency 150 kHz is reduced by roughly 20 dB, curve a, in comparison with a switching unit without a coil 9, curve b.

The invention is not restricted to the above described preferred embodiments only, but many modifications are possible within the scope of the inventive idea defined in the appended claim.

## Claims

1. An arrangement for eliminating radio interference in an electronic power regulator, said power regulator comprising a switching unit (1) and a control unit (2), said switching unit (1) including two semiconductor switching units (5, 6) coupled in parallel, the first being a transistor switching unit (5) and the second a tyristor switching unit (6); said switching unit (1) is coupled in series with the load (3), and the power regulator regulates the AC current fed in the load, so that by means of the control unit (2), during the half-cycle of the mains voltage, at a point of time (t), the transistor switching unit (5) is first switched to conductive state, and immediately thereafter the tyristor switching unit (6) is also switched to conductive state, and most advantageously both switching units (5, 6) are switched to cut-off state at the next zero point of the half-cycle, **characterised in that** the arrangement comprises a coil (9) with a low inductance, or a corresponding inductor, which is arranged in series with the tyristor switching unit (6), so that the tyristor switching unit (6) and the coil (9) are in parallel with the transistor switching unit (5).

## Patentansprüche

1. Anordnung zur Funkentstörung in einem elektronischen Leistungs-Regulierer, wobei der Leistungs-Regulierer eine Schalteinheit (1) und eine Steuer-/Regeleinheit (2) umfasst, wobei die Schalteinheit (1) zwei parallel gekoppelte Halbleiter-Schalteinheiten (5, 6) umfasst, wobei die erste eine Transistor-Schalteinheit (5) und die zweite eine Thyristor-Schalteinheit (6) ist, wobei die Schalteinheit (1) in Serie mit dem Verbraucher (3) gekoppelt ist, und der Leistungs-Regulierer den in den Verbraucher eingespeisten Wechselstrom reguliert, so dass vermittels der Steuer-/Regeleinheit (2) während der Halbwelle der Netzspannung, zu einem Zeitpunkt (t) die Transistor-Schalteinheit (5) zuerst in einen leitenden Zustand geschaltet wird, und unmittelbar danach die Thyristor-Schalteinheit (6) auch in einen leitenden Zustand geschaltet wird, und am meisten bevorzugt beide Schalteinheiten (5,6) bei dem nächsten Nullpunkt der Halbwelle in einen Sperrzustand geschaltet werden,
**dadurch gekennzeichnet, dass** die Anordnung eine Spule (9) mit einer niedrigen Induktivität oder einen entsprechenden Induktor umfasst, die oder der in Serie mit der Thyristor-Schalteinheit (6) angeordnet ist, so dass die Thyristor-Schalteinheit (6) und die Spule (9) parallel zu der Transistor-Schalteinheit (5) sind.

## Revendications

1. Montage pour éliminer des interférences radio dans un régulateur d'alimentation électronique, le dit régulateur d'alimentation comprenant un ensemble de commutation (1) et un ensemble de commande (2), le dit ensemble de commutation (1) comprenant deux ensembles de commutation à semi-conducteur (5, 6) couplés en parallèle, le premier étant un ensemble de commutation à transistor (5) et le second un ensemble de commutation à thyristor (6) ; ledit ensemble de commutation (1) étant couplé en série avec la charge (3), et le régulateur d'alimentation régulant le courant alternatif fourni à la charge (3), de sorte que, au moyen de l'ensemble de commande (2), pendant la demi-période de la tension réseau, à un instant (t), l'ensemble de commutation à transistor (5) est d'abord commuté pour passer à l'état conducteur, et immédiatement après l'ensemble de commutation à thyristor (6) est aussi commuté pour passer à l'état conducteur, et, de façon la plus avantageuse, les deux ensemble de commutation (5, 6) sont commutés pour passer à l'état bloqué au point zéro suivant de la demi-période, **caractérisé par le fait que** le montage comprend une bobine (9) à faible inductance, ou un inducteur correspondant, qui est montée en série avec l'ensemble de commutation à thyristor (6), de sorte que l'ensemble de commutation à thyristor (6) et la bobine (9) sont en parallèle avec l'ensemble de commutation à transistor (5).
